(19) Europäisches Patentamt
European Patent Office
Office européen des brevets

(11) **EP 1 995 599 A1**

(12) **EUROPEAN PATENT APPLICATION**

(43) Date of publication:
**26.11.2008 Bulletin 2008/48**

(51) Int Cl.:
*G01R 29/08* [(2006.01)]     *G01R 29/10* [(2006.01)]

(21) Application number: **07108888.4**

(22) Date of filing: **24.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicants:
• **Seiko Epson Corporation**
  **Shinjuku-ku**
  **Tokyo 163-0811 (JP)**
• **Universitat Politecnica de Catalunya**
  **08034 Barcelona (ES)**

(72) Inventors:
• **Jofre Roca, Lluis**
  **UNIVERSITAT POLITECNICA DE CATALUNYA**
  **Campus Nord UPC,Edif. D-3**
  **Jordi Girona, 1-3**
  **Barcelona 08034 (ES)**
• **Romeu Robert, Jordi**
  **UNIVERSITAT POLITECNICA DE CATALUNYA**
  **Campus Nord UPC,Edif. D-3**
  **Jordi Girona, 1-3**
  **Barcelona 08034 (ES)**

• **Blanch Boris, Sebastià**
  **UNIVERSITAT POLITECNICA DE CATALUNYA**
  **Campus Nord UPC,Edif. D-3**
  **Jordi Girona, 1-3**
  **Barcelona 08034 (ES)**
• **Serrano Calvo, Raquel**
  **UNIVERSITAT POLITECNICA DE CATALUNYA**
  **Campus Nord UPC,Edif. D-3**
  **Jordi Girona, 1-3**
  **Barcelona 08034 (ES)**
• **Cairo Molins, Josep Ignasi**
  **c/o EPSON EUROPE ELECTRONICS GmbH**
  **Modul C 2a planta**
  **Sant Cugat del Vallés - Barcelona 08190 (ES)**

(74) Representative: **Carpintero Lopez, Francisco et al**
  **Herrero & Asociados, S.L.**
  **Alcalá 35**
  **28014 Madrid (ES)**

(54) **Method for determining an antenna parameter**

(57)     The method for determining an antenna parameter comprises the steps of:
feeding (11) a first antenna (1) to produce a first output radiation (12);
subjecting an antenna under test (2), loaded with a load device (3) having an impedance arranged to vary in accordance with an external signal, to said first radiation (12);
applying said external signal (31) to the load device (3) so as to modulate the load of said antenna under test;
detecting scattered radiation comprising a modulated component (13) originating from said antenna under test;
determining at least one antenna parameter of the antenna under test (2).

*FIG. 1*

**Description**

FIELD OF THE INVENTION

The invention relates to the measurement of antenna parameters such as antenna radiation efficiency or antenna gain.

STATE OF THE ART

The ongoing trend towards miniaturization of communication devices (such as mobile telephones) implies a need for a significant reduction of the electrical and physical size of antennas. The reduction of the electrical size has a negative impact on bandwidth and antenna radiation efficiency.

In general, antennas tend to have their optimal behaviour at resonant lengths that are around $\lambda/2$ (or $\lambda/4$ in some cases where metal planes are used), $\lambda$ being the operating wavelength. Considering mobile telecommunication systems such as the GSM system, the initial resonant size $\lambda/2$ (or $\lambda/4$) of the antennas tends to be prohibitive, due to the size restriction imposed by the compactness of the devices. At 800-1000 MHz the wavelength is around 35 cm, whereby $\lambda/2$ will be in the order of 17 cm. Current wireless sensor microsystems are evolving towards a desired form factor of a few mm$^3$, which corresponds to a size of $\lambda/10$ to $\lambda/20$. The performance of electromagnetic passive devices is sensitive to the electrical size compared to the wavelength, i.e., given an operating wavelength and a certain performance, classical antennas cannot be made arbitrarily small, while simultaneously keeping certain operative parameters within specified limits. As a matter of fact, bandwidth, losses and dimensions of the antenna are closely interrelated in small antennas. Reduction of the electrical size of an antenna normally takes place at the expense of other parameters, such as bandwidth and antenna radiation efficiency. Thus, antenna miniaturization implies a compromise between different parameters involved.

An important parameter when dealing with small antennas is the radiation efficiency. The antenna radiation efficiency ($\eta$) can be defined as:

$$\eta = \frac{P_{rad}}{P_{in}} = \frac{P_{rad}}{P_{rad} + P_{loss}} = \frac{R_{rad}}{R_{rad} + R_{loss}}$$

wherein $P_{in}$ is the input power, $P_{rad}$ is the radiated power, $P_{loss}$ is the lost power, $R_{rad}$ is the radiation resistance and $R_{loss}$ is the loss resistance of the antenna. The relation of the antenna radiation efficiency ($\eta$) with the gain (G) is given by the expression G=$\eta$*D, wherein D is the directivity of the antenna.

The physical reduction of the antennas implies significant measurement difficulties, for example, if conventional antenna measurement equipment is to be used. Miniature antennas are comparable in size to common test equipments, which thus tend to perturb the normal behaviour of the antenna under test (AUT). Although there are current methods to measure antenna radiation efficiency or gain that can be considered practically non-invasive, there are still some limitations that impede an accurate characterization of small antennas.

A simple way to characterize a small antenna is by connecting it to test equipment though an unbalanced port. However, when working with balanced antennas such as with dipole antennas, the asymmetry at the input port gives rise to spurious radiation, which influences the result. The spurious radiation can be attenuated by means of the use of ferrite cores, chokes or baluns, but these structures often have a narrow bandwidth and, also, a large size compared to the size of a small antenna under test.

The so-called Wheeler cup method (cf. Wheeler, H.A., "The Radiansphere Around a Small Antenna". Proc IRE, pp. 1325-1331, August 1959) requires the use of a metallic plane, and is thus only suitable for characterizing antennas which have a ground plane. As mentioned above, the antenna radiation efficiency can be defined as:

$$\eta = \frac{P_{rad}}{P_{in}} = \frac{P_{rad}}{P_{rad} + P_{loss}} = \frac{R_{rad}}{R_{rad} + R_{loss}}$$

Thus, in order to calculate the antenna radiation efficiency, a possible approach can be based on measuring the total resistance and the loss resistance, and subsequently calculate the radiation resistance ($R_{rad}=R_{lot}-R_{loss}$). With the help of a network analyzer, the input resistance of an antenna can be obtained, thus making it possible to easily measure the total resistance. The loss resistance can be acquired by removing the radiation resistance and measuring, once more, the input resistance of the system. The radiation resistance is removed by surrounding the antenna by a grounded sphere (the cup). In this way, if the input impedance is once again measured with the network analyzer, the loss resistance is obtained.

An advantage of the Wheeler cup method is its simplicity. However, if the losses in the substrate are substantial, the Wheeler cup method will not provide an accurate result. Moreover, if the equivalent circuit of the antenna is more complex than just an RLC series circuit, some adjustments and approximations need to be made. Further, the method requires that the antenna has a ground plane of reasonable size.

Another well-known method is the so-called transmission power budget method. In order to avoid spurious radiation from the cables connected to the antenna under test, a VCO is connected directly to the input port of the antenna under test (AUT). From the outset, the transmitted power at the output of the VCO ($P_T$) and the gain ($G_R$) of a reference receiving antenna are known.

Thus, the power received at the reference antenna can be measured, and the gain ($G_T$) of the AUT (antenna under test) can be calculated applying the simple transmission equation

$$P_R = \frac{P_T G_T G_R}{\left(4\pi d/\lambda\right)^2}$$

wherein $P_R$ is the received power, $P_T$ is the transmitted power, $G_T$ the gain of the transmitter antenna (the antenna under test), $G_R$ is the gain of the receiver antenna, d is the distance between the two antennas and $\lambda$ is the wavelength.

Now, this method entails the use of a VCO connected to the port of the antenna under test, what perturbs the measurement when dealing with very small antennas.

Another method of analysing antenna parameters is based on the use of a so-called reverberation chamber. The reverberation chamber is a cavity where the electromagnetic modes (spatial distribution of the electric and magnetic fields inside the cavity) are stirred mechanically in order to obtain all possible plane wave directions incident on the antenna under test. This creates a Rayleigh distribution, which is the approximate distribution that exists in real environments. Therefore, the antennas are characterized in a scenario which resembles their actual working electromagnetic conditions. Nevertheless, this measurement technique entails the use of cables, which are quite long in many occasions, connected to the small antenna under test and therefore perturbing the measurement. Moreover, for a high accuracy of the measurement, the received power has to be measured in sufficient different positions of the stirrers inside the chamber, thus making the measurement process very time-consuming.

Another well-known method for antenna analysis is the so-called calorimetric method (cf., for example, Schroeder, W.L. and Gapski, D., "Direct Calorimetric Measurement of Small Antenna Radiation Efficiency", Antennas and Propagation Society International Symposium, 2005, Vol. 2B, pp. 744-747). However, the calorimetric method requires cables connected to the antenna port, in order to supply the input power, which means that the cables might perturb the antenna characterization. Moreover, to have an accurate knowledge of the power dissipated by the antenna it is necessary to know its return loss.

None of the current measurement methods is focused on the characterization of small active antennas under non-invasive conditions that faithfully reproduce their actual working environment.

DESCRIPTION OF THE INVENTION

A first aspect of the invention relates to a method for determining an antenna parameter, comprising the steps of:

feeding a first antenna to produce a first output radiation emitted by said first antenna;
subjecting an antenna under test, loaded with a load device (such as a photodiode, a phototransistor, or any other suitable device) having an impedance arranged to vary in accordance with an external signal, to said first radiation;
applying said external signal (such as an optical signal) to the load device so as to modulate the load of said antenna under test so as to produce a modulated radiation scattered back by the antenna under test;
detecting scattered radiation comprising a modulated component originating from said antenna under test, and a non-modulated component, so as to obtain a first output signal having a first modulated output component corresponding to said modulated component, and a first non-modulated output component corresponding to said non-modulated component; and
determining, on the basis of said first modulated output component, at least one antenna parameter of the antenna under test.

Thus, the invention makes it possible to measure, in a practical way, the gain of the antenna, and to estimate the antenna radiation efficiency, from the measured gain of the antenna, based on the knowledge of the approximate directivity for small antennas. It involves measuring the scattered field created by the antenna when it is irradiated by an incident field. In order to relate this backscattered field to the transmit/receive parameters of the small antenna, it is necessary to differentiate it from the unwanted scattering from the background and the structural scatter of the antenna itself. The modulation of the load impedance located at the antenna port makes it possible to mark the signal re-radiated (or backscattered) by the antenna under test, making this precise differentiation possible. The antenna parameters to be determined, for example, the gain, can be estimated by comparing the results obtained from the setup including the antenna under test with those obtained when repeating the measurement but replacing the antenna under test by a reference antenna, whose gain is known.

Thus, the present invention basically involves the use, for the purpose of measuring parameters of small antennas, of the so-called Modulated Scattering Technique, which employs an array of electrically small scattering probes modulated at audio frequencies to map the electric field over a near-field surface (cf. for example, Cown, B., et al., "Accuracy and speed characteristics of the bistatic MST for rapid near-field antenna measurements", IEEE APS International Symposium 1987, Vol. 25, pp 174-177), The near-field of the transmitting antenna under test is scattered from the MST array. The scattered field may be received by the test antenna itself (monostatic set-up) or by an auxiliary antenna (bistatic set-up). The method is further explained in Bolomey, Gardiol, "Engineering Applications of the Modulated Scatterer Technique", Artech House Publishers, 2001.

The backscattering technique is a non-invasive and non-perturbing method, since the antenna is characterized without any extra connector or cable. In this way, the actual working environment of the antenna is reproduced.

Contrarily, most of the traditional measurement setups use unbalanced ports, so when measuring a balanced antenna, unbalanced to balanced transition is needed. The backscattering technique is appropriate for both balanced and unbalanced antenna ports, which represents a significant advantage.

Once a backscattering technique setup has been prepared, the actual measurements can be performed very rapidly, thus, the method also serves to speed up the measurement of the small antennas.

As suggested above, the step of determining, on the basis of said first modulated output component, at least one antenna parameter of the antenna under test, can comprise the steps of further subjecting a reference antenna to said first radiation, modulating a load (for example, the same load as applied to the antenna under test, or an identical or similar load device, which can be modulated by an identical or similar external signal as the one used for the antenna under test) of said reference antenna, detecting scattered radiation comprising a modulated component originating from said reference antenna, and a non-modulated component, and obtaining a second output signal having a second modulated output component corresponding to said modulated component originating from said reference antenna and a second non-modulated component, and comparing said first modulated output component with said second modulated output component so as to determine said at least one antenna parameter.

The step of determining, on the basis of said first modulated output component, at least one antenna parameter of the antenna under test, can further comprise the step of calculating the gain of the antenna under test on the basis of the formula

$$(G_{AUT})^2 = (G_{REF})^2 * ((P_R/P_T)_{AUT}) / ((P_R/P_T)_{REF})$$

wherein $G_{REF}$ is the gain of the reference antenna, $(P_R/P_T)_{AUT}$ is the ratio between the power of the first modulated output component and the power input to the first antenna for producing the first radiation, and $(P_R/P_T)_{REF}$ is the ratio between the power of the second modulated output component and the power input to the first antenna for producing said first radiation, and $G_{AUT}$ is the gain of the antenna under test.

The first modulated output component and/or the second modulated output component can be measured at an output end of the first antenna.

The load device can be a device having an impedance arranged to vary in accordance with an electromagnetic field or radiation applied to the load device, for example, in accordance with an optical signal applied to the load device. For example, the load device can comprise a photodiode or a phototransistor. The step of applying said external signal to the load device can comprise the step of applying an optical signal to said load device, so as to modulate the impedance of the load device in accordance with said optical signal.

Alternatively, in accordance with other embodiments of the invention, the load device can be a device having an impedance arranged to vary in accordance with an acoustic (or electric, or magnetic) signal applied to the load device, and the step of applying said external signal to the load device can comprise the step of applying an acoustic signal (or electric, or magnetic) to said load device, so as to modulate the impedance of the load device in accordance with said acoustic (or electric, or magnetic) signal.

Basically, according to one aspect of the invention, the load device can be some kind of electronic modulator device sensitive to at least one of

- electromagnetic radiation (such as light),
- magnetic coupling,
- electric coupling, and
- acoustic signals;

so as to allow for externally controlled variation of the impedance of the load device using an external modulator, that is, some kind of external device providing some kind of signals to the load device in order to modulate the impedance of the load applied to the antenna.

The antenna under test can, for example, be attached to a thread supporting said antenna under test in a test position so as to receive radiation from said first antenna.

Said at least one antenna parameter can comprise the antenna gain and/or the antenna radiation efficiency.

BRIEF DESCRIPTION OF THE DRAWINGS

To complete the description and in order to provide for a better understanding of the invention, a set of drawings is provided. Said drawings form an integral part of the description and illustrate a preferred embodiment of the invention, which should not be interpreted as restricting the scope of the invention, but just as an example of how the invention can be embodied. The drawings comprise the following figures:

Figure 1: Schematically illustrates a setup according to one possible embodiment of the invention.
Figure 2: Schematically illustrates the setup as a cuadripole or two-port network.

DESCRIPTION OF A PREFERRED EMBODIMENT OF THE INVENTION

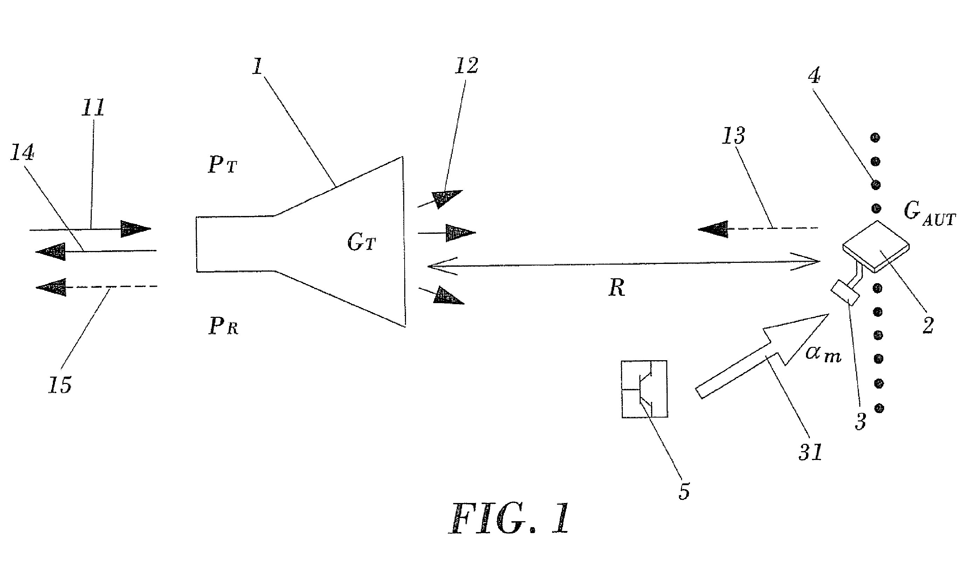

In figure 1, one possible setup for implementation of the invention can be observed, wherein a radiating antenna or first antenna 1 (with gain $G_T$) is fed with an input signal 11 (corresponding to an input power $P_T$) for generating a first radiation 12, emitted by said radiating first antenna 1 and received, in part, by the antenna under test 2, which is positioned at a distance R from the first antenna 1, for example, in front of the first antenna. The antenna under test 2 is fixed in its position in the air by a thread 4.

A light-sensitive device 3 (such as a photodiode, phototransistor or another non-linear electronic device, having an impedance that varies in accordance with the changes in an external signal 31 provided by an external light-source 5, is arranged as the antenna load. It is well known that the backscattering produced by an antenna depends on the antenna characteristics expressed in terms of its angular directivity and its antenna impedance, and also on the impedance of the load applied to the antenna terminals. As a consequence, when the impedance of the load applied to the antenna terminal(s) changes, the electromagnetic field backscattered by the antenna changes accordingly. In order to clearly mark the field backscattered by the antenna and differentiate it from the environmental spurious random scattered reflections and other unwanted scattered waves, the load is changed (modulated) in a very precise way between two or more well known different states, for example, open circuit, short circuit and a known impedance, at a precise frequency rate. To produce this controlled change rate (modulation), the switching electronic device (in this embodiment, the light-sensitive device) is activated using an external light-source modulating signal 31 generated by a corresponding light-source 5.

Thus, the first radiation gives rise to a scattered radiation, comprising a non-modulated component originating from the test environment, and a modulated component 13 originating from the antenna under test 2 and modulated by said non-linear electronic device 3 to have a certain modulation index $\alpha_m$. These two components of scattered radiation are received by the first antenna 1 and generate, at an output port of the antenna 1, a corresponding output signal comprising a first non-modulated output component 14 and a first modulated output component 15. By means of coherent detection at the receiving end (at an output end of the first antenna), said first modulated output component 15 is separated from the first non-modulated output component 14 (that is, basically, the part of the output signal originating from the antenna under test is separated from the part of the output signal that is caused by unwanted reflected scattering corresponding to the noisy background and to the geometrical properties of the antenna under test itself), and the power content $P_R$ of said first modulated output component 15 is determined.

Subsequently, the same process is repeated, but using a reference antenna, with a known antenna gain ($G_{REF}$), instead of the antenna under test 2, obtaining a second modulated output component and a second non-modulated output component, which are separated at the output end of the first antenna.

Using the radar equation

$$\frac{P_R}{P_T} = G_T^2 \left( \frac{\lambda}{4\pi R} \right)^4 \alpha_m G_{AUT}^2$$

(wherein λ is the wavelenght) and comparing the modulated components of the output signals measured in relation with the antenna under test and the reference antenna, respectively, the following relation is obtained:

$$(G_{AUT})^2 / (G_{REF})^2 \quad = \quad (P_R/P_T)_{AUT} / (P_R/P_T)_{REF}$$

wherein

- G_{AUT} is the antenna gain of the antenna under test,
- G_{REF} is the antenna gain of the reference antenna,
- $(P_R/P_T)_{AUT}$ is the ratio between the power of the first modulated output component (originating from the antenna under test) and the power input to the transmitting first antenna,
- and $(P_R/P_T)_{REF}$ is the ratio between the power of the second modulated output component (originating from the reference antenna) and the power input to the transmitting first antenna.

Thus, knowing the power $P_R$ of the modulated output components separated and measured during the measurements on the antenna under test and the reference antenna, respectively, as well as the gain of the reference antenna, the gain of the antenna under test can be calculated.

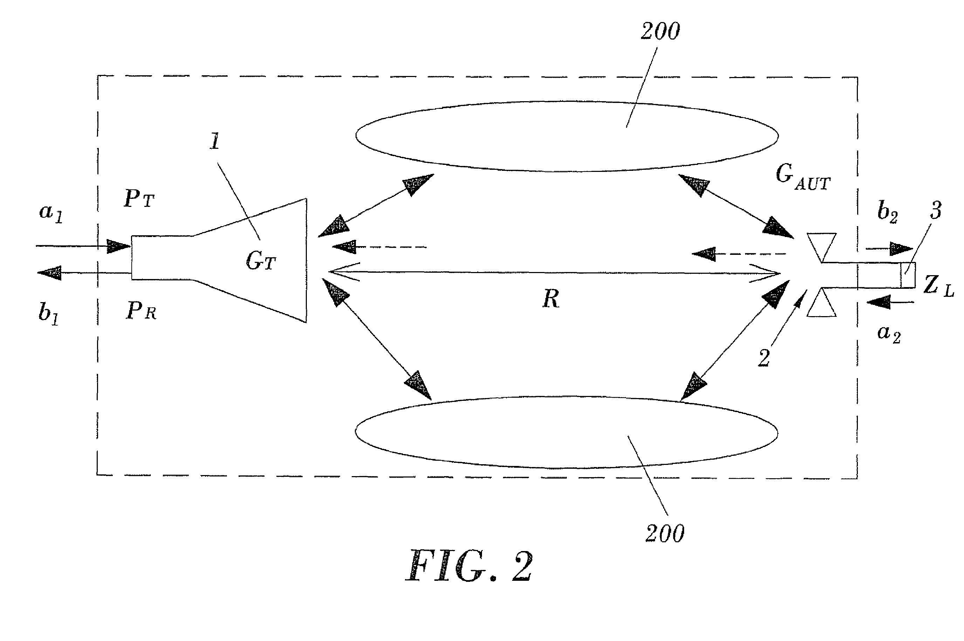

For a more complete understanding of the backscattering method and using an approach as suggested in Wiesbeck, W. & Heidrich, E., "Wide-Band Multiport Antenna Characterization by Polarimetric RCS Measurements", IEEE Transactions on Antennas and Propagation, vol 46, no. 3, pp. 341-350, March 1998, the setup can be considered as a cuadripole or two-port network, as shown in Fig 2, illustrating the radiating first antenna 1 (gain $G_T$), the antenna under test 2 (gain $G_{AUT}$, load $Z_L$), and two obstacles 200 that contribute to scattered radiation. Therefore, studying the cuadripole following the common microwave theory (cf. for example, David M. Pozar, "Microwave Engineering", John Wiley & Sons, Inc.,3rd Ed., 2005), the normalized incident waves ($a_n$) and reflected normalized amplitude waves ($b_n$) at each one of the two ports (n=1,2), can be expressed by:

$$a_n = V_n^+ / \sqrt{Z_{0n}}$$

$$b_n = V_n^- / \sqrt{Z_{0n}}$$

( $V_n^+$ and $V_n^-$ being, respectively, the incident and reflected voltage waves at port n and $Z_{0n}$ the characteristic impedance of the *nth* port).

From the *David M. Pozar* document mentioned above, it follows that a generalized scattering matrix can be used to relate the incident and reflected waves defined above:

$$[b] = [S] \cdot [a]$$

where the i,jth element of the scattering matrix is given by

$$S_{ij} = \left.\frac{b_i}{a_j}\right| \text{ being } a_k = 0 \text{ for } k \neq j$$

Thus, the reflection factor $\rho_1$ can be defined by the following formula:

$$\rho_1 = b_1 / a_1$$

The measured reflection factor $\rho_1$ at the input port of the calibrated first antenna 1 is composed by three different contributions, namely:

- the scatter from the background, which would be the scatter without the antenna under test 2 ($P_{1noAUT}$)
- the scatter from the structural scatter, which is due to the geometrical properties of the antenna under test 2 itself, since it is a metallic object with a certain radar cross Section ($\rho_{1structural-scatt.}$)
- the scatter due to the re-radiation of the antenna under test 2 ($\rho_{1re-radiated}$), which is related to the gain $G_{AUT}$ of said antenna 2 and the following expression:

$$\frac{\rho_L S_{21}^2}{1 - \rho_L S_{22}}$$

wherein $\rho_L$ is the reflection coefficient of the load $Z_L$.

Thus, the reflection factor can be expressed in analytical form by the formula:

$$\Gamma_1 = \rho_{1noAUT} + \rho_{1structural-scatt} + \rho_{1re-radiated}$$

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

**Claims**

1. Method for determining an antenna parameter, comprising the steps of:

> feeding (11) a first antenna (1) to produce a first output radiation (12) emitted by said first antenna;
> subjecting an antenna under test (2), loaded with a load device (3) having an impedance arranged to vary in accordance with an external signal, to said first radiation (12);
> applying said external signal (31) to the load device (3) so as to modulate the load of said antenna under test (2) so as to produce a modulated radiation scattered back by the antenna under test (2);
> detecting scattered radiation comprising a modulated component (13) originating from said antenna under test (2), and a non-modulated component, so as to obtain a first output signal (14, 15) having a first modulated output component (15) corresponding to said modulated component (13), and a first non-modulated output component (14) corresponding to said non-modulated component;
> determining, on the basis of said first modulated output component (15), at least one antenna parameter of the antenna under test (2).

2. Method according to claim 1, wherein the step of determining, on the basis of said first modulated output component (15), at least one antenna parameter of the antenna under test (2), comprises the steps of further subjecting a reference antenna to said first radiation, modulating a load of said reference antenna, detecting scattered radiation comprising a modulated component originating from said reference antenna, and a non-modulated component, and obtaining a second output signal having a second modulated output component corresponding to said modulated component originating from said reference antenna and a second non-modulated component, and comparing said first modulated output component (15) with said second modulated output component so as to determine said at least one antenna parameter.

3. Method according to claim 2, wherein the step of determining, on the basis of said first modulated output component, at least one antenna parameter of the antenna under test, further comprises the step of calculating the gain of the antenna under test (2) on the basis of the formula

$$(G_{AUT})^2 = (G_{REF})^2 * ((P_R/P_T)_{AUT}) / ((P_R/P_T)_{REF})$$

wherein $G_{REF}$ is the gain of the reference antenna, $(P_R/P_T)_{AUT}$ is the ratio between the power of the first modulated output component (15) and the power input (11) to the first antenna (1) for producing the first radiation (12), and $(P_R/P_T)_{REF}$ is the ratio between the power of the second modulated output component and the power input to the first antenna for producing said first radiation, and $G_{AUT}$ is the gain of the antenna under test.

4. Method according to any of the preceding claims, wherein the first modulated output component (15) is measured at an output end of said first antenna (1).

5. Method according to any claims 2-3, wherein the first modulated output component (15) and the second modulated output component are both measured at an output end of the first antenna (1).

6. Method according to any of the preceding claims, wherein the load device (3) is a device having an impedance arranged to vary in accordance with an electromagnetic radiation applied to the load device.

7. Method according to claim 6, wherein the load device is a device having an impedance arranged to vary in accordance with an optical signal applied to the load device.

8. Method according to claim 7, wherein the load device is a photodiode.

9. Method according to claim 7, wherein the load device is a phototransistor.

10. Method according to any of the preceding claims, wherein the step of applying said external signal to the load device comprises the step of applying an optical signal (31) to said load device, so as to modulate the impedance of the load device in accordance with said optical signal.

11. Method according to any of claims 1-5, wherein said load device is a device having an impedance arranged to vary in accordance with an acoustic signal applied to the load device, and wherein the step of applying said external signal to the load device comprises the step of applying an acoustic signal to said load device, so as to modulate the impedance of the load device in accordance with said acoustic signal.

12. Method according to any of claims 1-5, wherein said load device is a device having an impedance arranged to vary in accordance with an electric signal applied to the load device, and wherein the step of applying said external signal to the load device comprises the step of applying an electric signal to said load device, so as to modulate the impedance of the load device in accordance with said electric signal.

13. Method according to any of claims 1-5, wherein said load device is a device having an impedance arranged to vary in accordance with a magnetic signal applied to the load device, and wherein the step of applying said external signal to the load device comprises the step of applying a magnetic signal to said load device, so as to modulate the impedance of the load device in accordance with said magnetic signal.

14. Method according to any of claims 1-5, wherein the load device (3) is an electronic modulator device sensitive to at least one of

- electromagnetic radiation,
- magnetic coupling,
- electric coupling, and
- acoustic signals;

so as to allow for externally controlled variation of the impedance of the load device using an external modulator.

15. Method according to any of the preceding claims, wherein the antenna under test is attached to a thread (4) supporting said antenna under test in a test position so as to receive radiation from said first antenna (1).

16. Method according to any of the preceding claims, wherein said at least one antenna parameter comprises the antenna gain.

17. Method according to any of claims 1-15, wherein said at least one antenna parameter comprises the antenna radiation efficiency.

*FIG. 1*

*FIG. 2*

**European Patent Office**

**EUROPEAN SEARCH REPORT**

Application Number

EP 07 10 8888

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 410 324 A (BOLOMEY JEAN-CHARLES [FR] ET AL) 25 April 1995 (1995-04-25) * figure 1 * ----- | 1-17 | INV. G01R29/08 G01R29/10 |
| | | | TECHNICAL FIELDS SEARCHED (IPC) |
| | | | G01R |

The present search report has been drawn up for all claims

| Place of search | Date of completion of the search | Examiner |
|---|---|---|
| The Hague | 28 September 2007 | Vytlacilová, Lenka |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 10 8888

This annex lists the patent family members relating to the patent documents cited in the above-mentioned European search report.
The members are as contained in the European Patent Office EDP file on
The European Patent Office is in no way liable for these particulars which are merely given for the purpose of information.

28-09-2007

| Patent document cited in search report | Publication date | Patent family member(s) | | Publication date |
|---|---|---|---|---|
| US 5410324 A | 25-04-1995 | CA | 2063017 A1 | 15-09-1992 |
| | | FR | 2674028 A1 | 18-09-1992 |
| | | JP | 3479311 B2 | 15-12-2003 |
| | | JP | 5251926 A | 28-09-1993 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **WHEELER, H.A.** The Radiansphere Around a Small Antenna. *Proc IRE,* August 1959, 1325-1331
- **SCHROEDER, W.L. ; GAPSKI, D.** Direct Calorimetric Measurement of Small Antenna Radiation Efficiency. *Antennas and Propagation Society International Symposium,* 2005, vol. 2B, 744-747
- **COWN, B. et al.** Accuracy and speed characteristics of the bistatic MST for rapid near-field antenna measurements. *IEEE APS International Symposium,* 1987, vol. 25, 174-177
- **BOLOMEY ; GARDIOL.** Engineering Applications of the Modulated Scatterer Technique. Artech House Publishers, 2001
- **WIESBECK, W. ; HEIDRICH, E.** Wide-Band Multiport Antenna Characterization by Polarimetric RCS Measurements. *IEEE Transactions on Antennas and Propagation,* March 1998, vol. 46 (3), 341-350
- **DAVID M. POZAR.** Microwave Engineering. John Wiley & Sons, Inc, 2005